(19) **Europäisches Patentamt**
**European Patent Office**
**Office européen des brevets**

(11) **EP 4 411 395 B1**

## (12) FASCICULE DE BREVET EUROPEEN

(45) Date de publication et mention
de la délivrance du brevet:
**17.09.2025 Bulletin 2025/38**

(21) Numéro de dépôt: **24155132.4**

(22) Date de dépôt: **31.01.2024**

(51) Classification Internationale des Brevets (IPC):
**G01R 31/08** (2020.01)    **G01R 31/11** (2006.01)
**H02H 7/00** (2006.01)    **H01F 6/02** (2006.01)

(52) Classification Coopérative des Brevets (CPC):
**G01R 31/11; G01R 31/081; H01F 6/02; H02H 7/001**

(54) **MÉTHODE DE DÉTECTION D'UNE TRANSITION FORTUITE D'ÉTAT DANS UNE LIGNE CONDUCTRICE, EN PARTICULIER UNE LIGNE SUPRACONDUCTRICE**

**VERFAHREN ZUR ERKENNUNG EINES STARKEN ZUSTANDSÜBERGANGS IN EINER LEITERLEITUNG, INSBESONDERE EINER SUPRALEITENDEN LEITUNG**

**METHOD FOR DETECTING A NON-CONTINUOUS STATE TRANSITION IN A CONDUCTIVE LINE, IN PARTICULAR A SUPERCONDUCTING LINE**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **03.02.2023 FR 2301023**

(43) Date de publication de la demande:
**07.08.2024 Bulletin 2024/32**

(73) Titulaire: **Commissariat à l'Energie Atomique et aux Energies Alternatives**
**75015 Paris (FR)**

(72) Inventeurs:
- **COHEN, Josy**
**91191 Gif-sur-Yvette Cedex (FR)**
- **REVAULT, Louise**
**91191 Gif-sur-Yvette Cedex (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
**US-A1- 2018 328 975    US-A1- 2021 278 452
US-A1- 2022 170 978**

- **BEZIUK GRZEGORZ ET AL: "Locating Electrical Faults in Superconducting Accelerator Magnets Using Time Domain Reflectometry", vol. 28, no. 3, 4 December 2017 (2017-12-04), USA, pages 1 - 5, XP093076064, ISSN: 1051-8223, Retrieved from the Internet <URL:https://ieeexplore.ieee.org/stampPDF/getPDF.jsp?tp=& arnumber=8128497& ref=aHR0cHM6Ly93d3cuZ29vZ2xlLmNvbS8=> DOI: 10.1109/TASC.2017.2779495**
- **BANG SU SIK ET AL: "Abnormality Monitoring for Three-Phase HTS Cable via Time-Frequency Domain Reflectometry", IEEE TRANSACTIONS ON APPLIED SUPERCONDUCTIVITY, IEEE, USA, vol. 31, no. 5, 18 February 2021 (2021-02-18), pages 1 - 6, XP011844124, ISSN: 1051-8223, [retrieved on 20210313], DOI: 10.1109/TASC.2021.3060364**

**Description**

L'invention concerne le domaine des méthodes de surveillance et de diagnostic de l'état de santé d'une ligne conductrice, en particulier d'une ligne en matériau supraconducteur telle qu'une bobine supraconductrice.

L'invention porte sur une méthode et un système permettant de détecter l'apparition d'une transition fortuite d'état, en particulier lié au passage d'un état supra à un état résistif dans une ligne supraconductrice telle qu'une bobine. L'invention vise également à suivre l'évolution d'une telle transition et fournir des informations permettant de localiser la zone de la ligne impactée.

L'invention s'applique à tout système dans lequel des lignes conductrices ou supraconductrices sont utilisées, telles que des bobines, enroulements ou câbles électriques.

En ce qui concerne les matériaux supraconducteurs, ceux-ci sont caractérisés par des valeurs limites interdépendantes de courant, température et champ magnétique qui permettent de conserver les propriétés supraconductrices. Si l'une de ces limites est dépassée localement, une transition fortuite locale de l'état supra vers un état résistif se propage dans le matériau. Ce phénomène est généralement désigné par le terme anglais « quench ». Dans la suite de la description, on utilisera le terme transition fortuite d'état pour désigner l'apparition d'un « quench ». La perte de propriété supraconductrice du matériau signifie qu'il devient résistant et donc effectue une transition vers un état résistif (à l'inverse de l'état supra où le matériau présente une résistance nulle). Ce phénomène augmente localement la température du matériau et peut entrainer une détérioration irréversible, voire une destruction des matériaux du fait de la très grande densité de courant. Les causes d'une transition fortuite d'état sont diverses, elles peuvent notamment venir d'une source extérieure à la ligne, d'un défaut sur la ligne ou d'une fragilité.

Pour ces raisons, il est important de pouvoir détecter ces transitions avant qu'elles se propagent dans la ligne. En règle générale, ces transitions sont détectées par des mesures de tension qui sont invasives et pour le cas des matériaux supraconducteurs haute température critique, pas assez sensibles et donc rapides. Cela pose un frein à leur développement industriel malgré leurs performances bien meilleures que celles des matériaux supraconducteurs basse température critique.

La théorie des matériaux supraconducteurs et leur comportement ne sont pas entièrement connus à ce jour. Il est donc important de pouvoir étudier ces transitions et leur propagation.

Par ailleurs, il existe un besoin similaire pour détecter et suivre l'évolution de défauts sur des câbles électriques constitués de matériau conducteurs.

Un objectif principal de la présente invention consiste à proposer une nouvelle méthode de détection, suivi et localisation de transitions fortuites dans des lignes conductrices, en particulier en matériau supraconducteur, et en particulier pour des lignes arrangées sous forme de bobines.

Un objectif secondaire de l'invention consiste en outre à proposer une méthode de réflectométrie qui prenne en compte la forte désadaptation à l'entrée du système en particulier pour les bobines.

Les systèmes actuels de détection de transition fortuite dans des matériaux supraconducteurs sont basés sur des mesures de tension. Par exemple, dans les applications liées à l'étude de la matière, notamment les applications nucléaires, il s'agit du système de détection primaire. L'objectif d'un tel système de détection est de mesurer le terme résistif de la tension dans la bobine. La valeur de la tension au cours du temps dans la bobine est donnée par la formule suivante :

$$U_i(t) = R_i I_i + L_i \frac{dI_i}{dt} + \sum_{k=1}^{k=N} M_{ik} \frac{dI_k}{dt}$$

- $R_i I_i$ est la tension résistive qui correspond à ce que l'on cherche à mesurer pour détecter une transition fortuite ;

- $L_i \frac{dI_i}{dt}$ est la tension inductive liée à l'inductance de la bobine ;

- $\sum_{k=1}^{k=N} M_{ik} \frac{dI_k}{dt}$ est la tension inductive liée à l'inductance mutuelle de la bobine avec N autres circuits.

Pour ne conserver que le premier terme de l'équation à savoir la tension résistive, il est possible de compenser la tension surveillée par une tension similaire prise sur un autre sous-composant.

La surveillance d'un matériau supraconducteur par mesure de tension fonctionne bien sur les systèmes supraconducteurs à basse température critique **LTS** (< *20K*).

Pour les systèmes supraconducteurs à haute température critique **HTS** (aux alentours de *70K*), la vitesse de propagation de la transition est plus lente. Pour de tels systèmes HTS, les méthodes par mesure de tension ne détectent les transitions fortuites que trop tardivement pour avoir une protection efficace du système.

D'autres méthodes de détection de transitions fortuites sans mesure de tension ont été proposées parmi lesquelles :

- Des techniques magnétiques basées sur des mesures de changement de champ magnétique, par exemple utilisant des antennes à quench ou des réseaux de capteurs Hall,

- Des techniques optiques basées sur des mesures de déformations ou de changement de température, par exemple utilisant des capteurs à réseaux de Bragg, des techniques de diffusion de Rayleigh ou de Brillouin, Raman ou des fibres spécialisées,

- Des techniques acoustiques passives par mesure d'émissions acoustiques,

- Des techniques acoustiques actives par diffusion d'ondes ultrasonores pour mesurer des changements de fonction de transfert,

- Des techniques capacitives basées sur l'ébullition d'un liquide cryogénique.

Il existe par ailleurs des méthodes de détection basées sur des techniques de réflectométrie qui visent à identifier des changements d'impédance dans une ligne conductrice ou supraconductrice par l'intermédiaire d'une injection dans la ligne d'un signal de test puis par la mesure de la rétro-propagation de ce signal au point d'injection.

La publication [1] décrit une méthode de réflectométrie temporelle appliquée à des bobines supraconductrices à température ambiante. La méthode proposée permet de localiser un court-circuit entre un bobinage et le cryostat et des court-circuits entre des spires de la bobine. Il est cependant nécessaire d'ajuster les paramètres des impulsions du signal de test en fonction de chaque circuit. Il faut pour cela réaliser une analyse de la réponse fréquentielle de la bobine et du spectre du signal. La méthode nécessite d'ajouter un câble de retard avant la bobine à tester pour éviter d'avoir du recouvrement.

La publication [2] décrit une autre méthode de réflectométrie temporelle qui implique une simulation puis une comparaison entre une méthode par mesure de tension et une méthode de réflectométrie temporelle. La méthode est applicable à une bobine supraconductrice à environ 70K. Il est constaté que le signal de réflectométrie n'est pas assez stable dans la réalité pour pouvoir détecter une transition fortuite. En effet, en réflectométrie temporelle le seuil de détection doit être placé plus haut que pour les mesures de tension pour ne pas avoir de fausses détections. Un retard de 10 secondes est constaté entre les deux détections. Il est conclu qu'il est possible d'utiliser la réflectométrie temporelle pour vérifier l'impédance de la bobine (et donc son bon fonctionnement) avant de l'alimenter.

D'autres méthodes décrites dans [3] et [4] sont basées sur une méthode de réflectométrie en temps fréquence (TFDR) couplée ou non à une transformée de Wigner-Ville.

Dans [3], l'objectif est de diagnostiquer la présence de défaut(s) d'isolation sur un câble HTS à l'aide d'une réflectométrie temps fréquence. Des mesures de réflectométrie temporelle sont aussi réalisées pour comparaison. Les mesures sont réalisées à température ambiante et à la température de l'azote liquide. Il est constaté qu'avec la réflectométrie temporelle, le défaut n'est pas assez visible parmi le bruit pour être détecté. Au contraire, la méthode temps fréquence permet de le détecter et le localiser.

Dans [4], l'objectif est de surveiller des câbles HTS triphasés avec un test de réflectométrie temps-fréquence car les systèmes habituels ne permettent de ne surveiller qu'une phase. Une transition fortuite est réalisée sur une phase à l'aide d'un chauffage local et l'objectif est de trouver la phase en défaut ainsi que la distance du défaut. Les transitions fortuites sont détectées en surveillant les changements de tendance de l'indicateur basé sur la distribution de Wigner-Ville.

Une autre méthode décrite dans [5] a pour objectif de surveiller les caractéristiques électriques et thermiques d'un système de câble HTS du réseau de Séoul avec une méthode de réflectométrie temps-fréquence. La température lors des mesures est aux alentours de 70K. Les expériences sont réalisées lorsque le système est déconnecté du réseau pour l'inspection de routine. Il est constaté qu'il n'est pas possible de déterminer exactement la température mais il est possible de suivre son évolution.

Une autre méthode décrite dans [6] a pour objectif de détecter un changement de température locale sur un câble HTS à l'aide d'une méthode temps fréquence.
Une simulation et des mesures sont réalisées par réflectométrie temporelle et temps-fréquence. La simulation montre que le défaut est visible à l'aide des deux méthodes, mais très peu avec la méthode temporelle et plus clairement avec la méthode temps fréquence. Les mesures confirment les résultats obtenus par simulation : le changement de température est noyé dans le bruit pour le cas de la méthode temporelle.

La publication [7] décrit encore une autre méthode basée sur une technique de réflectométrie utilisant un signal particulier dont la fréquence varie par paliers.

Le document US2021/278452A1 divulgue un procédé de caractérisation d'un défaut dans un réseau de lignes de transmission de topologie inconnue, basé sur le principe de la réflectométrie.

Enfin, le brevet européen EP-415709 décrit un capteur hydraulique pour la détection et la localisation des transitions d'état dans des supraconducteurs.

Toutes les méthodes de l'art antérieur précitées présentent un ou des inconvénient(s) parmi les suivants :

- Les mesures réalisées sur le matériau sont invasives ;
- Les mesures et/ou le traitement sont trop long(s) pour la détection vis-à-vis de la vitesse d'évolution du phénomène,
- Pas de possibilité de réguler le système, celui-ci doit être déchargé quasi-systématiquement ;
- Les méthodes ne donnent pas d'information sur la proportion du système qui est transitée ;

L'invention vise à proposer une nouvelle méthode de détection, suivi et localisation de transitions d'état fortuites dans un matériau supraconducteur, en particulier dans une bobine ou une ligne supraconductrice ou conductrice.

La méthode proposée est basée sur une surveillance de l'évolution de certains paramètres d'un réflectogramme temporel qui sont modifiés lorsque la vitesse de propagation du signal change. Ainsi l'invention permet de détecter un changement de vitesse du signal qui traduit l'apparition d'une transition d'état du matériau. En particulier, un paramètre surveillé est la position temporelle, dans le réflectogramme, du pic correspondant à l'extrémité de la ligne conductrice qui peut évoluer lorsque la vitesse du signal change.

L'invention s'applique à la détection de défauts dans des lignes conductrices, sous forme de câbles ou de bobines, mais aussi aux lignes en matériau supraconducteur.

L'invention s'applique notamment à la surveillance de l'état de santé de systèmes électriques comportant des bobinages, tels que des moteurs, alternateurs, enroulements pour des domaines d'applications variés qui vont du nucléaire au médical, à l'aéronautique ou à l'énergie.

L'invention a pour objet une méthode de détection d'une transition fortuite dans une ligne conductrice, comprenant les étapes de :

- Réaliser au moins une première mesure de réflectométrie de référence sur la ligne conductrice consistant au moins à injecter un signal de test dans la ligne, à mesurer une réflexion du signal de test rétropropagé et en déduire un réflectogramme temporel de référence,

- Identifier au moins une caractéristique du réflectogramme temporel de référence parmi : la position temporelle d'au moins un pic d'amplitude, un nombre de pics d'amplitude dans le réflectogramme, l'amplitude d'au moins un pic d'amplitude,

- Réaliser au moins une seconde mesure de réflectométrie sur la ligne conductrice pour obtenir un second réflectogramme temporel,

- Identifier la même au moins une caractéristique dans le second réflectogramme temporel et,

- Pour chaque pic d'amplitude identifié, déterminer une différence entre l'au moins une caractéristique mesurée sur le réflectogramme temporel de référence et la même caractéristique mesurée sur le second réflectogramme temporel,

- Evaluer, sur plusieurs mesures successives si ladite différence augmente en valeur absolue et si c'est le cas, déclencher une alerte correspondant à l'apparition d'une transition fortuite.

Selon un aspect particulier de l'invention, l'étape d'évaluer si la différence augmente en valeur absolue consiste à comparer la valeur absolue de la différence à un seuil prédéterminé et à déclencher l'alerte si le seuil est dépassé.

Selon un aspect particulier de l'invention, l'au moins un pic d'amplitude est le dernier pic d'amplitude du réflectogramme temporel correspondant à une réflexion du signal de test sur l'extrémité de la ligne conductrice.

Selon un aspect particulier de l'invention, plusieurs mesures de réflectométrie sont réalisées et moyennées respectivement pour déterminer le réflectogramme temporel de référence et le second réflectogramme temporel.

Selon un aspect particulier de l'invention, la ligne conductrice est une bobine conductrice.

Selon un aspect particulier de l'invention, les mesures de réflectométrie sont réalisées en :

- Superposant ladite bobine conductrice à une seconde bobine de référence de longueur inférieure à la longueur de la bobine conductrice, ayant un diamètre de conducteur supérieur au diamètre de conducteur de la bobine conductrice et ayant un diamètre extérieur de la bobine de référence sensiblement identique au diamètre extérieur de la bobine conductrice,

- Connectant un dispositif de réflectométrie apte à réaliser une mesure de réflectométrie au moyen d'un câble coaxial ayant deux conducteurs respectivement reliés à la bobine conductrice et à la seconde bobine de référence.

Selon un aspect particulier de l'invention, la seconde bobine de référence est en cuivre.

Selon un aspect particulier de l'invention, l'au moins une caractéristique d'un réflectogramme temporel correspond à plusieurs pics d'amplitude du réflectogramme temporel et une différence est calculée respectivement entre la position temporelle de chaque pic d'amplitude du réflectogramme temporel de référence et du second réflectogramme.

Dans une variante de réalisation, la méthode selon l'invention comprend une étape de localisation de la transition fortuite sur la ligne conductrice au moyen d'un affichage sur une interface visuelle de l'évolution au cours du temps des différences calculées en fonction de la position temporelle de chaque pic d'amplitude.

Selon un aspect particulier de l'invention, la ligne conductrice est en matériau supraconducteur et la transition fortuite correspond à une transition d'un état supra à un état résistif.

Dans une variante de réalisation, la méthode selon l'invention comprend en outre une étape de coupure ou diminution du courant dans la ligne conductrice lorsque l'alerte est déclenchée.

L'invention a aussi pour objet un système de détection d'une transition fortuite dans une ligne conductrice comprenant un dispositif de réflectométrie apte à réaliser une mesure de réflectométrie dans la ligne conductrice et une unité de traitement configurée pour exécuter les étapes de la méthode de détection d'une transition fortuite selon l'invention.

D'autres caractéristiques et avantages de la présente invention apparaîtront mieux à la lecture de la description qui suit en relation aux dessins annexés suivants.

[Fig. 1a] représente un schéma d'un premier exemple d'un système de réflectométrie temporelle,

[Fig. 1b] représente un schéma d'un second exemple d'un système de réflectométrie temporelle,

[Fig. 2] représente un organigramme décrivant les étapes de mise en œuvre d'une méthode de détection de transition fortuite dans une ligne conductrice selon un premier mode de réalisation de l'invention,

[Fig. 3] illustre l'utilisation d'un couplage entre deux bobines pour réaliser une mesure de réflectométrie sur une bobine supraconductrice,

[Fig. 4] représente un exemple de réflectogramme obtenu au moyen du dispositif décrit à la figure 3,

[Fig. 5] représente sur un diagramme temporel un premier exemple d'évolution de plusieurs paramètres en présence d'une transition fortuite dans une bobine supraconductrice,

[Fig. 6] représente sur plusieurs diagrammes, un second exemple d'évolutions de plusieurs paramètres en présence d'une transition fortuite dans une bobine supraconductrice,

[Fig. 7] représente un organigramme d'un second mode de réalisation de l'invention,

[Fig. 8] représente un exemple de localisation de pics d'amplitude dans un réflectogramme temporel,

[Fig. 9] représente un premier exemple d'affichage des résultats du second mode de réalisation,

[Fig. 10] représente un second exemple d'affichage des résultats du second mode de réalisation.

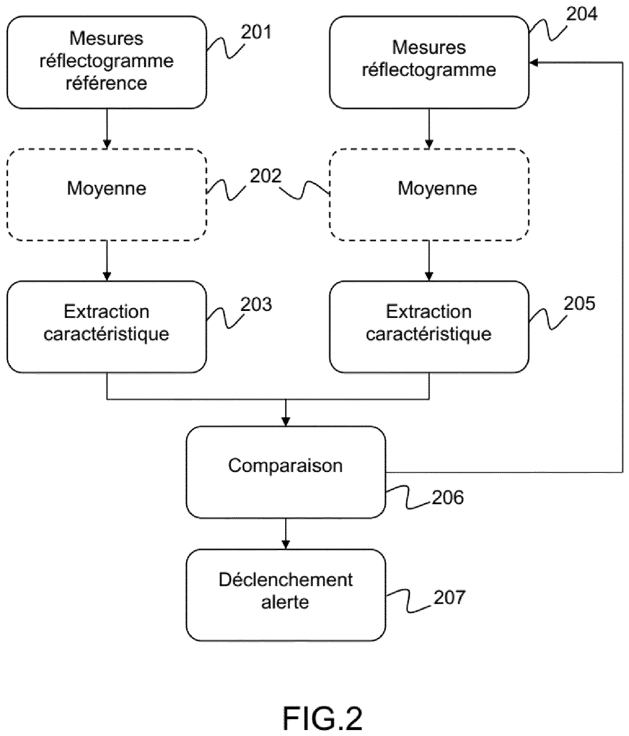

La figure 2 schématise, sur un organigramme, les étapes de mise en œuvre d'une méthode de détection de transition fortuite dans une ligne conductrice selon un premier mode de réalisation de l'invention.

Selon ce premier mode de réalisation, l'invention est appliquée à la détection d'une transition d'un état supra vers un état résistif pour un matériau supraconducteur, par exemple une bobine supraconductrice.

Lorsqu'un tel phénomène se produit, le matériau passe dans un état résistif, c'est-à-dire que sa résistance augmente (à partir d'une valeur nulle dans l'état supra) et donc le courant se propageant dans le matériau augmente.

L'augmentation de la résistance entraine également une variation de la vitesse de propagation d'un signal de réflectométrie se propageant dans le matériau. L'invention exploite ce phénomène afin de détecter l'apparition de telles transitions fortuites.

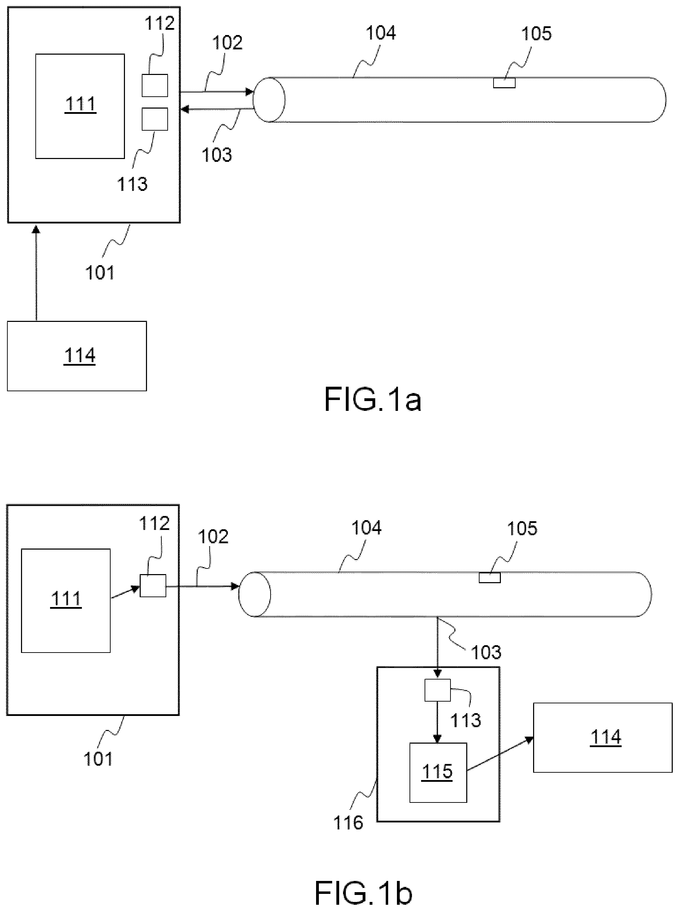

Pour cela, la méthode débute à l'étape 201 avec une ou plusieurs mesures par réflectométrie réalisées sur une bobine supraconductrice prise dans un état de référence. Pour cela on utilise un dispositif de réflectométrie connu dont le principe est rappelé aux figures 1a et 1b.

Sur la figure 1a, on a représenté une ligne conductrice, par exemple un câble, à tester 104 qui présente un défaut 105 à une distance quelconque d'une extrémité du câble.

Un système de réflectométrie 101 comprend un composant électronique 111 de type circuit intégré, tel un circuit à logique programmable, par exemple de type FPGA, ou micro-contrôleur, adapté à exécuter deux fonctions. D'une part, le composant 111 permet de générer un signal de réflectométrie s(t) à injecter dans le câble 104 sous test. Ce signal généré numériquement est ensuite converti via un convertisseur numérique-analogique 112 puis injecté 102 à une extrémité du câble. Le signal s(t) se propage dans le câble et est réfléchi sur la singularité engendrée par le défaut 105. Le signal réfléchi est rétropropagé jusqu'au point d'injection 106 puis capturé 103, converti numériquement via un convertisseur analogique-numérique 113, et transmis au composant 111. Le composant électronique 111 est en outre adapté, à partir du signal s(t) reçu, à déterminer un réflectogramme ou plusieurs réflectogrammes. Le système de réflectométrie 101 peut, plus généralement être mis en œuvre au moyen d'un analyseur de réseau, d'un réflectomètre temporel ou d'un oscilloscope apte à générer des signaux.

Le ou les réflectogramme(s) peuvent être transmis à une unité de traitement 114, de type ordinateur, assistant numérique personnel ou autre pour afficher les résultats des mesures sur une interface homme-machine.

Le système 101 décrit à la figure 1a est un exemple de réalisation nullement limitatif. En particulier les deux fonctions exécutées par le composant 111 peuvent être séparées dans deux composants ou dispositifs distincts comme cela est illustré sur l'exemple de la figure 1b. Le point d'injection et le point de mesure du signal peuvent également être pris en des endroits quelconques du câble et non à son extrémité.

Sur la figure 1b, on a représenté un premier dispositif 101 dédié à la génération du signal de réflectométrie et à son injection dans le câble et un second dispositif 116 dédié à la mesure du signal en un point quelconque du câble puis au calcul du réflectogramme via un composant 115.

Le composant 115 peut être un composant électronique de type circuit intégré, tel un circuit à logique programmable, par exemple de type FPGA ou un microcontrôleur, par exemple un processeur de signal numérique, qui reçoit les mesures de signal et est configuré pour exécuter le procédé selon l'invention. Le composant 115 comporte au moins une mémoire pour sauvegarder les derniers échantillons de signal généré et injecté dans le câble et les derniers échantillons de signal mesuré.

Comme cela est connu dans le domaine des méthodes de diagnostic par réflectométrie temporelle, la position $d_{DF}$ d'un défaut 105 sur le câble 104, autrement dit sa distance au point d'injection du signal, peut être directement obtenue à partir de la mesure, sur le réflectogramme temporel calculé R(t), de la durée $t_{DF}$ entre le premier pic d'amplitude relevé sur le réflectogramme et le pic d'amplitude correspondant à la signature du défaut.

Ce principe peut donc être utilisé pour réaliser une ou plusieurs mesures de réflectogrammes temporels sur une bobine supraconductrice.

Pour cela, le signal doit être injecté entre deux conducteurs par exemple au moyen d'un câble coaxial en utilisant l'âme centrale du câble comme premier conducteur et le blindage ou l'écran du câble comme second conducteur.

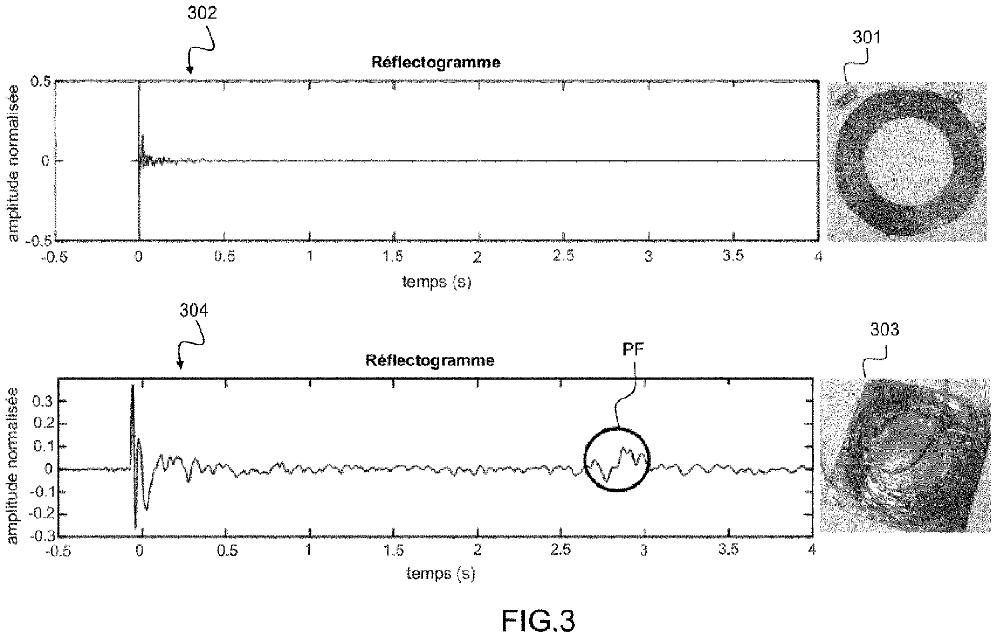

Un problème spécifique aux bobines ou autres bobinages de câbles est que la désadaptation à l'entrée du système peut être assez importante et engendrer un premier pic d'amplitude très élevé dans le réflectogramme. Ce phénomène est illustré sur la figure 3 qui illustre, sur deux exemples, une mesure de réflectogramme réalisée sur une bobine supraconductrice (non représentée à la figure 3). La mesure de réflectométrie est réalisée en connectant l'équipement de mesure (réflectomètre) à la bobine supraconductrice d'une part et à une bobine de référence d'autre part, via un câble coaxial. L'âme du câble coaxial est connectée à la bobine supraconductrice tandis que l'écran du câble coaxial est connecté à la bobine de référence 301,303, par exemple. Alternativement, il est aussi possible de connecter l'âme du câble coaxial à la bobine de référence et l'écran du câble coaxial à la bobine supraconductrice.

Le premier réflectogramme temporel 302 est obtenu en utilisant une bobine de référence 301 de même longueur que la bobine supraconductrice et dont les spires sont de mêmes dimensions que celles de la bobine supraconductrice. Autrement dit, la bobine de référence 301 présente les mêmes dimensions que la bobine de référence mais est, par exemple, simplement conductrice, par exemple il s'agit d'une bobine en cuivre.

Le réflectogramme 302 obtenu par cette mesure montre un pic de désadaptation dans le réflectogramme 302 ayant une amplitude si élevée qu'il va masquer d'éventuels autres pics ultérieurs correspondants à des défauts, en particulier pour un convertisseur analogique numérique de dynamique réduite. Cela est dû au fait que toute l'énergie du signal injecté est réfléchie sur cette désadaptation d'entrée de la bobine et le signal ne se propage alors pas dans le reste de la bobine. Il n'est donc pas possible d'observer des réflexions du signal au-delà du point d'entrée de la bobine

Une solution pour corriger ce problème consiste à utiliser comme bobine de référence, une bobine en cuivre 303 de longueur plus faible que la bobine supraconductrice mais de diamètre extérieur sensiblement identique, par exemple positionnée sous la bobine supraconductrice. Par exemple, l'âme du câble coaxial est connectée à la bobine supraconductrice tandis que l'écran du câble coaxial est connecté à la bobine de référence 303. Par exemple, la bobine supraconductrice a une longueur de 30m tandis que la bobine de référence 303 a une longueur de 3m, c'est-à-dire 10 fois moins longue. Le diamètre du conducteur utilisé pour réaliser la bobine de référence 303 est donc supérieur au diamètre du conducteur utilisé pour réaliser la bobine supraconductrice. Les deux bobines sont superposées l'une sur l'autre.

Le couplage des deux bobines permet d'atténuer le pic de désadaptation et d'identifier le pic correspondant à l'extrémité de la bobine PF sur le réflectogramme 304 alors qu'il n'était pas visible sur le réflectogramme 302.

La mesure de réflectométrie 304 ainsi réalisée est l'image du conducteur le plus court 303 donc théoriquement, de la précision est perdue au niveau de la mesure mais cela permet de visualiser de plus grandes longueurs de système étudié.

L'utilisation du couplage entre deux bobines de longueurs et diamètres de conducteurs différents permet de résoudre ce premier problème lié à l'amplitude du pic de désadaptation et de produire un réflectogramme temporel 304 exploitable.

Sans sortir du cadre de l'invention, d'autres dispositifs peuvent être utilisés en remplacement de la bobine de référence 303 pour annuler ou réduire l'amplitude du pic de désadaptation.

Un objectif de l'invention est d'analyser les mesures de réflectogramme temporels pour détecter un changement de vitesse du signal indicatif de l'apparition d'une transition fortuite.

Pour cela, une ou plusieurs mesures de références sont réalisées à l'étape 201 sur un conducteur initialement sain, c'est-à-dire dans son état supra.

Optionnellement, une étape de moyenne 202 est réalisée sur un ensemble de mesures afin de réduire le rapport signal à bruit.

A l'étape 203, on extrait une caractéristique particulière du réflectogramme parmi : la position temporelle du pic de fin de ligne, l'amplitude de ce pic ou le nombre de pics relevés sur le réflectogramme.

Par exemple, le dernier pic d'amplitude du réflectogramme correspond à la réflexion du signal sur l'extrémité de la ligne. Ce pic est ainsi toujours présent sur le réflectogramme même en l'absence totale de défaut.

Comme cela est connu, l'abscisse temporelle du dernier pic du réflectogramme est liée à la distance entre le point d'injection du signal et l'extrémité de la ligne par la relation $2xd = t_{PF} \cdot V$, où $V$ est la vitesse du signal qui dépend notamment des propriétés de la ligne supraconductrice. La distance d est égale à la longueur totale de la bobine dans le cas le plus général où le signal est injecté à une extrémité de la ligne.

Lorsqu'une transition fortuite apparait, la bobine supraconductrice passe localement d'un état supra à un état résistif ce qui peut provoquer des changements de température, courant ou champ magnétique. Ces changements entrainent ensuite une modification de la vitesse du signal de test se propageant dans la ligne.

Ainsi, si la vitesse $V$ change alors que la distance d est constante, l'abscisse temporelle $t_{PF}$ du pic de fin de ligne sur le réflectogramme va changer également.

L'invention exploite ce phénomène pour suivre et détecter l'apparition d'une transition fortuite d'état du matériau.

A l'étape 204, on réalise une ou plusieurs nouvelles mesures de réflectogrammes dans les mêmes conditions que celles réalisées à l'étape 201 pour la référence. Les mesures sont éventuellement moyennées (étape 202) puis à l'étape 205 on extrait du réflectogramme obtenu la même caractéristique qu'à l'étape 203, par exemple la position temporelle du pic de fin de ligne.

Si la vitesse du signal n'a pas changé, les positions mesurées aux étapes 203 et 206 sont sensiblement identiques, sinon un écart doit être observé.

Ainsi, à l'étape 206 on compare la valeur absolue de l'écart des deux positions à un seuil prédéterminé. Si ce seuil est dépassé, une alerte est déclenchée à l'étape 207 conduisant par exemple à couper le courant dans la bobine pour éviter son endommagement. Dans tous les cas, on retourne à l'étape 204 pour réaliser de nouvelles mesures périodiquement ou à un rythme prédéfini permettant la surveillance de l'évolution de la ligne.

Dans le cas où une alerte est déclenchée, celle-ci peut être transmise aux équipements assurant la sécurité du système comprenant la bobine supraconductrice pour un arrêt d'urgence ou une régulation du système en baissant le courant d'alimentation.

Dans le cas où le courant d'alimentation est baissé, la méthode peut se poursuivre en réalisant de nouvelles mesures 204 afin de suivre l'évolution de la transition et de détecter un retour de la bobine à l'état supra lorsque l'écart entre les deux positions repasse en dessous du seuil à l'étape 206.

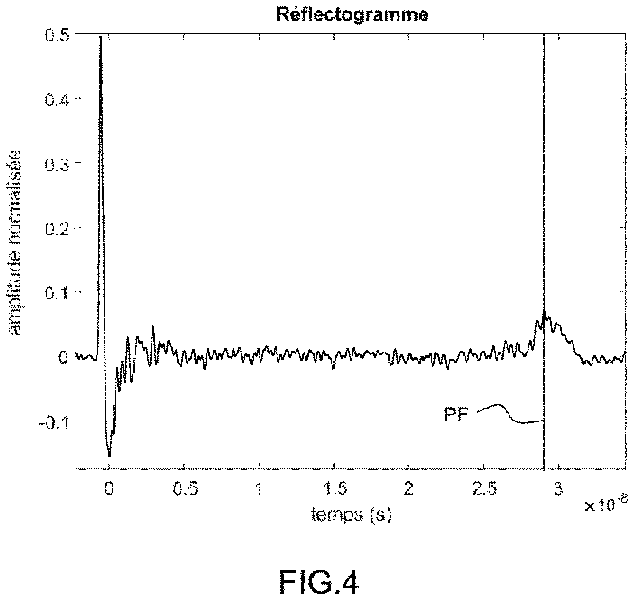

La figure 4 illustre sur un exemple de réflectogramme la position temporelle du pic de fin de ligne mesurée.

Dans une variante de réalisation, l'étape 206 peut consister à détecter une augmentation progressive de l'écart entre les positions mesurées en valeur absolue, signe de l'apparition d'une transition. Cette évaluation est alors réalisée sur plusieurs mesures successives.

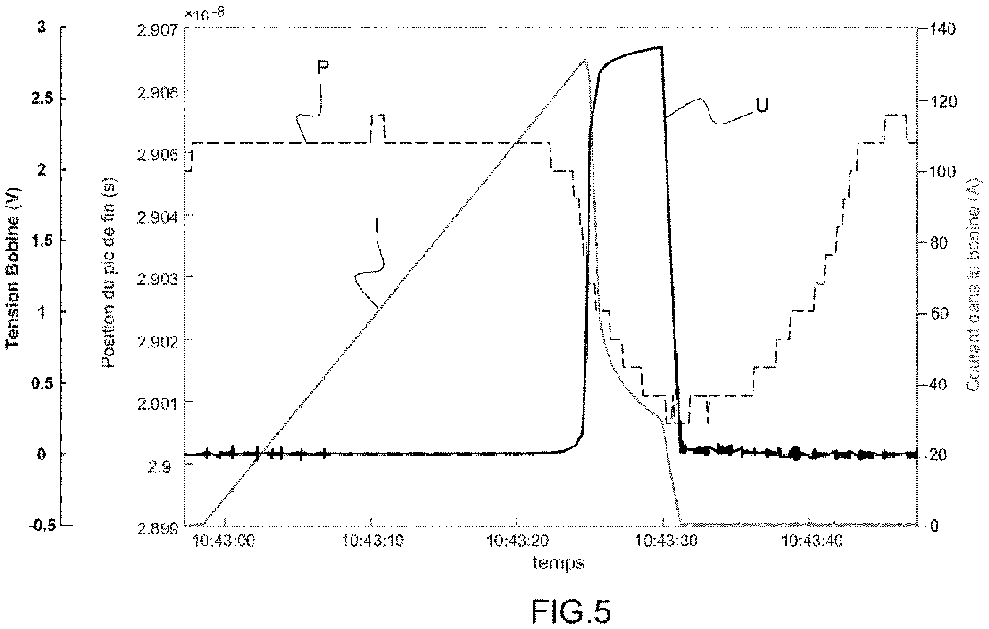

La figure 5 illustre l'impact d'une transition d'état de la bobine supraconductrice sur l'écart des positions temporelles mesurées à l'étape 206.

La figure 5 représente sur un même diagramme temporel l'évolution de la tension aux bornes de la bobine U, du courant traversant la bobine I et de l'évolution P de la position temporelle du pic de fin de ligne au cours du temps. Sur l'exemple de la figure 5, une transition est provoquée en augmentant le courant I dans la bobine progressivement jusqu'à ce que la tension aux bornes de la bobine U dépasse un seuil de tension. Lorsque ce seuil est atteint, le courant est coupé dans la bobine afin d'éviter son endommagement. La bobine est reliée à une résistance adaptée pour permettre sa décharge.

On peut voir sur la figure 5 que la position temporelle P du pic de fin de ligne diminue lorsque la tension U dépasse un certain seuil puis remonte lorsque la tension U diminue à nouveau. Dans cet exemple, la valeur de la position temporelle du pic de fin de ligne lorsque la bobine est à l'état supra correspond à la valeur maximale de la position P du pic de fin de ligne sur la figure 5.

Ainsi, en détectant une évolution de la position temporelle P du pic de fin de ligne par rapport à sa valeur de référence, il est possible de détecter l'apparition d'une transition fortuite d'état du matériau.

Selon une variante de réalisation, la position du pic de fin de ligne est remplacée par le nombre de pics détectés dans le réflectogramme en tant que caractéristique extraite du réflectogramme aux étapes 203, 205.

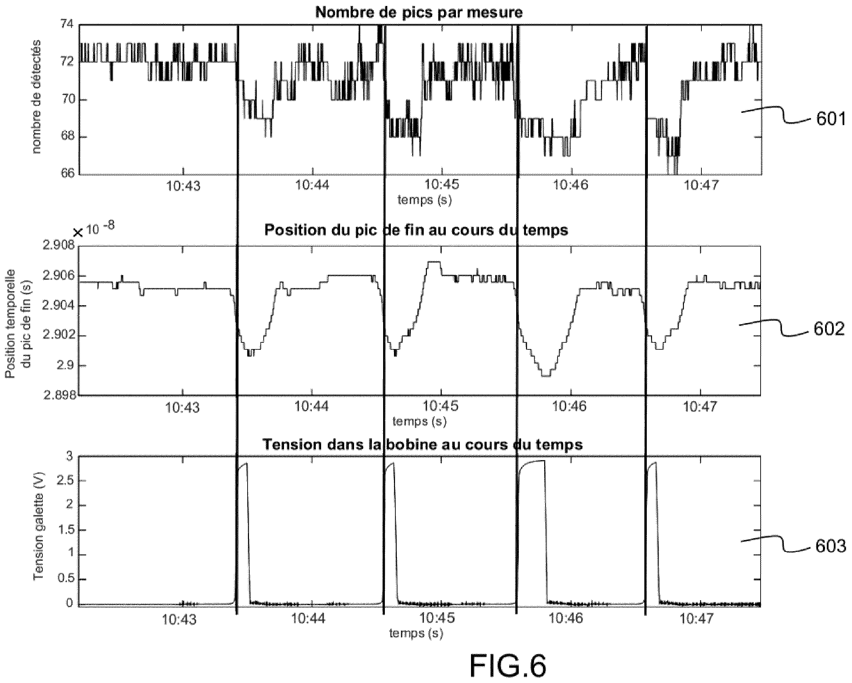

Dans ce cas, un seuil de détection est défini afin de séparer les pics correspondant à des réflexions du signal sur des discontinuités d'impédance de ceux correspondant à du bruit de mesure. On compte ensuite le nombre de pics du réflectogramme qui dépasse le seuil. Lorsque la vitesse du signal augmente lors de l'apparition d'une transition fortuite, le nombre de pics dans le réflectogramme diminue comme cela peut être observé sur la figure 6.

Le diagramme 601 représente le nombre de pics détectés dans le réflectogramme en fonction du temps. Le diagramme 602 représente la position du pic de fin dans le réflectogramme en fonction du temps. Le diagramme 603 représente l'évolution de la tension dans la bobine au cours du temps.

On remarque que le nombre de pics évolue tout comme la position du pic de fin lorsque la tension augmente dans la bobine signe de l'apparition d'une transition fortuite d'état.

Dans encore une autre variante de réalisation, la caractéristique extraite du réflectogramme est l'amplitude du pic de fin de ligne. En effet, cette amplitude varie également en fonction de la vitesse du signal dans le câble.

Dans encore une autre variante de réalisation, les étapes 203 et 205 de la méthode selon l'invention consistent à extraire plusieurs caractéristiques du réflectogramme parmi la position du pic de fin de ligne, le nombre de pics et l'amplitude du pic de fin de ligne et à déterminer un écart par rapport à une référence pour chacune de ces caractéristiques. Dans ce cas, à l'étape 206, une combinaison de ces écarts est calculée et comparée à un seuil prédéfini ou bien chacun des écarts est comparé à un seuil distinct et une alerte est déclenchée à l'étape 207 lorsqu'au moins un seuil est dépassé. Les seuils d'alerte sont déterminés a priori, par exemple par simulation ou test préalable.

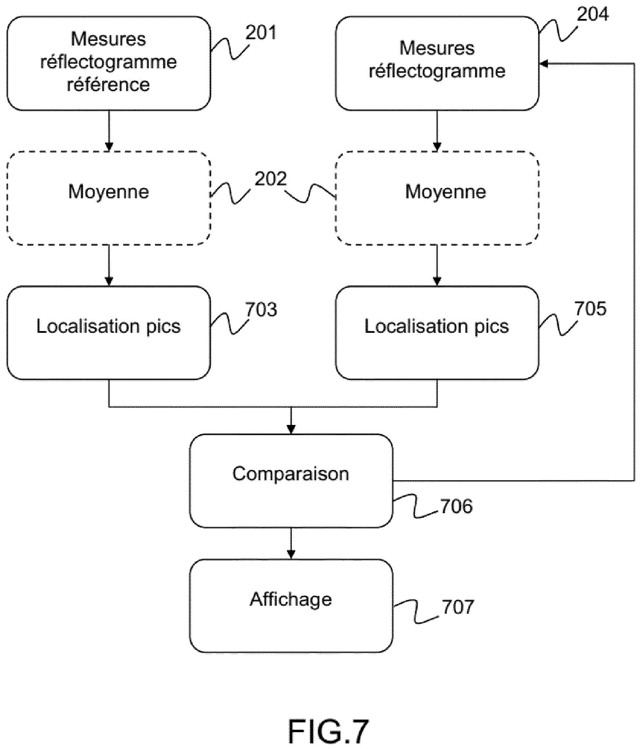

La figure 7 schématise, sur un organigramme, les étapes de mise en œuvre d'une méthode de détection, suivi et localisation de transition fortuite dans une ligne conductrice selon un second mode de réalisation de l'invention.

Dans ce second mode, les étapes initiales de mesures de réflectogramme 201, 204 et de moyenne 202 sont identiques à celles du premier mode de réalisation.

Contrairement au premier mode, les caractéristiques extraites du réflectogramme aux étapes 703, 705 correspondent cette fois à l'ensemble des positions temporelles des pics détectés dans le réflectogramme, c'est-à-dire les pics dont l'amplitude dépasse un certain seuil prédéfini.

Comme vu précédemment, une variation de la vitesse de propagation du signal entraine un décalage temporel de tous les pics du réflectogramme qui correspondent à des discontinuités d'impédance localisées en des points précis de la bobine.

Il est donc possible d'élargir la comparaison entre le réflectogramme de référence et un réflectogramme mesuré à un instant ultérieur à tous les pics initialement détectés.

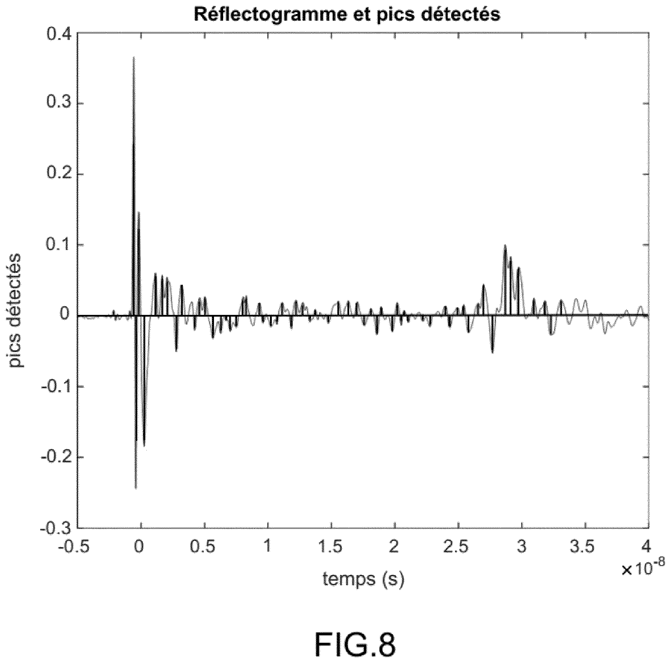

La localisation des pics est par exemple réalisée au moyen d'une transformation des extrema locaux du réflectogramme en une série de Dirac temporelle comme cela est représenté à la figure 8 sur un exemple.

A l'étape 706, le décalage de chaque pic par rapport à sa position dans la mesure de référence (obtenue à l'étape 703) est calculé.

Le suivi de l'évolution de ces écarts permet non seulement de détecter l'apparition d'une transition fortuite mais aussi de la localiser selon quels pics du réflectogramme évoluent. Par exemple, l'étape de comparaison 706 peut résulter en ce que seulement la position des pics situés en fin de ligne conductrice évolue tandis que la position des pics situés en début de ligne conductrice reste stable.

Les écarts de position calculés à l'étape 706 peuvent être affichés (étape 707) sur une interface utilisateur afin de visualiser l'apparition d'une transition et sa localisation dans le réflectogramme.

Plusieurs possibilités sont envisageables pour l'affichage des résultats à l'étape 707.

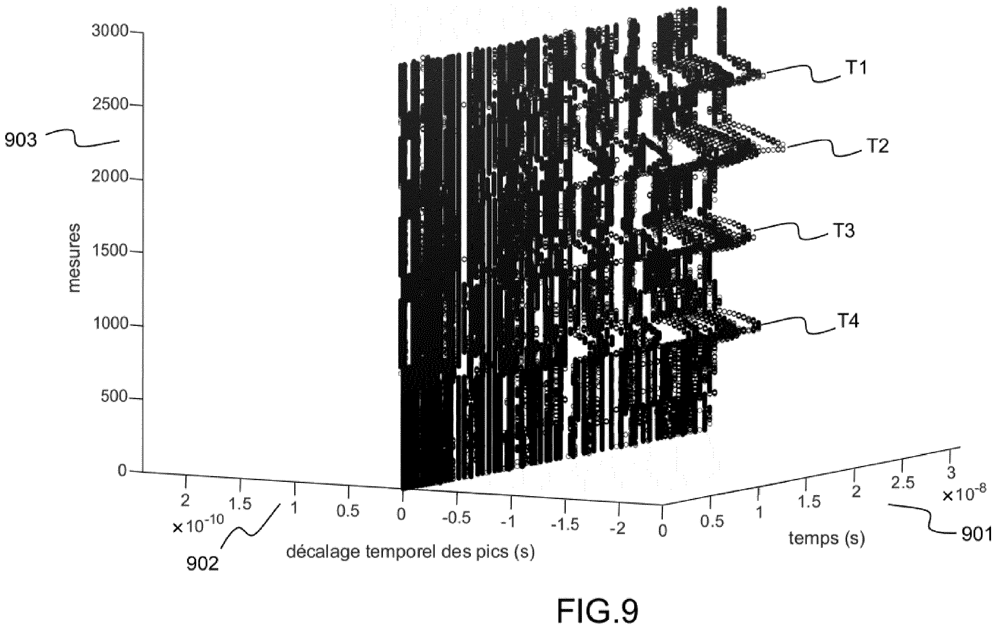

La figure 9 montre un premier type d'affichage possible sous la forme d'un diagramme en 3D dont le premier axe 901 correspond à l'axe des temps d'un réflectogramme, le deuxième axe 902 correspond à la valeur de l'écart temporel mesuré à l'étape 706 pour chaque pic et le troisième axe 903 correspond à une mesure de réflectogramme réalisée à un instant donné.

Dans l'exemple de la figure 9, quatre transitions fortuites successives T1,T2,T3,T4 apparaissent au cours du temps et sont plutôt situées au niveau de la fin du réflectogramme ce qui correspond à la moitié de la bobine située vers l'intérieur de la bobine, c'est-à-dire proche de son extrémité opposée au point d'injection du signal.

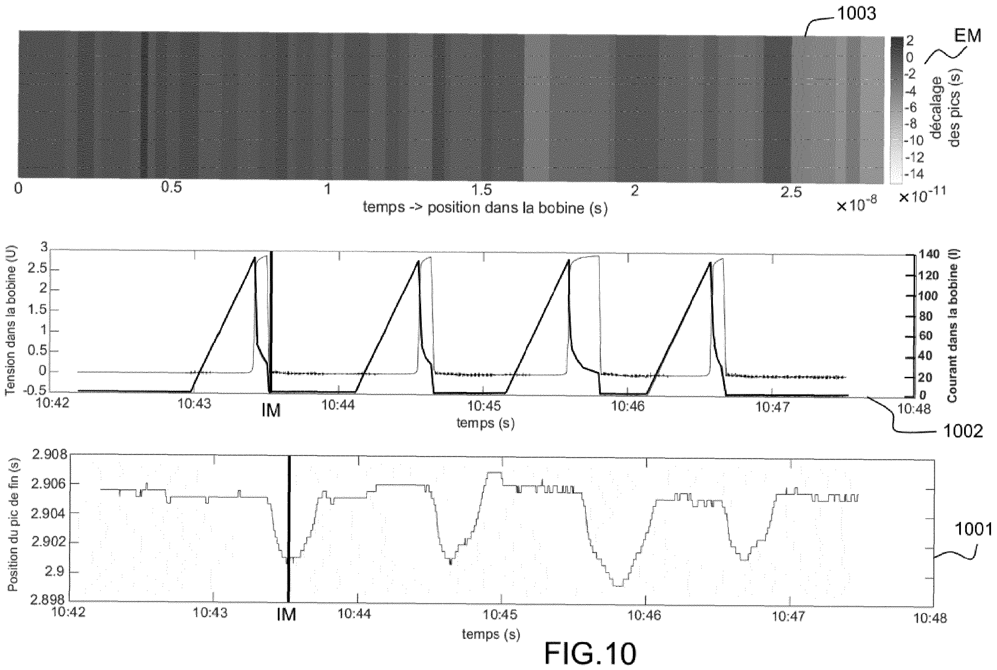

La figure 10 montre un second type d'affichage possible sous la forme d'une séquence de diagrammes temporels 1003. Sur la figure 10 on a représenté à titre illustratif l'évolution du courant et de la tension au cours du temps dans une bobine supraconductrice sur le diagramme 1002 ainsi que l'évolution de la position du pic de fin de ligne du réflectogramme sur le diagramme 1001.

Le diagramme 1003 représente la valeur de l'écart mesuré sur chaque pic du réflectogramme (représenté par l'échelle EM) à un instant donné (c'est-à-dire pour une mesure donnée). L'instant de la mesure correspondant au diagramme 1003 est identifié sur les diagrammes 1001 et 1002 par la référence IM.

Les axes temporels des diagrammes 1001 et 1002 correspondent à un axe des mesures (chaque point correspond à une mesure de réflectogramme réalisé à un instant donné).

L'axe temporel du diagramme 1003 correspond à l'axe des temps d'un réflectogramme qui représente donc le temps de propagation aller-retour du signal le long de la bobine. Les valeurs des écarts de position élevée sont représentées par un niveau de gris plus clair que les valeurs d'écarts faibles représentées par un niveau de gris plus sombre.

Ainsi, dans le diagramme 1003, chaque position temporelle correspond à un pic identifié dans le réflectogramme à l'étape 705. Sur l'exemple de la figure 10, on peut identifier que les positions des pics de la seconde moitié du réflectogramme évoluent davantage que ceux de la première moitié ce qui indique l'apparition d'une transition fortuite dans la seconde moitié de la bobine située à l'intérieur de la bobine.

Le diagramme 1003 est affiché sur une interface utilisateur pour chaque nouvelle mesure, ce qui permet de visualiser l'évolution au cours du temps des écarts des positions des pics le long du réflectogramme et ainsi identifier l'évolution spatiale d'une transition fortuite le long de la bobine.

L'invention peut être mise en œuvre au moyen d'un dispositif du type décrit aux figures 1a et 1b qui comporte un équipement de mesure de réflectométrie pour injecter un signal de test dans une bobine et mesurer la réflexion du signal afin de produire un réflectogramme temporel. Le moyen de couplage décrit en figure 3 peut être utilisé pour limiter l'amplitude du pic de désadaptation d'impédance d'entrée de la bobine.

L'équipement de mesure est couplé à une unité de traitement pour exécuter les étapes de la méthode de détection de transition d'état selon un mode de réalisation de l'invention et à une interface de visualisation pour afficher les résultats produits par la méthode.

[1] "Locating electrical faults in superconducting accelerator magnets using time domain reflectometry. IEEE TRANSACTIONS ON APPLIED SUPERCONDUCTIVITY", Grzegorz Beziuk, A. S. (2018).

[2] Bin Chen, Y. H. (2020). Research on quench detection method using radio frequency wave technology. IEEE TRANSACTIONS ON APPLIED SUPERCONDUCTIVITY.

[3] Geon Seok Lee, G.-Y. K.-H.-J. (2016). Time-frequency-based insulation diagnostic technique oh high-temperature superconducting cable systems. IEEE TRANSACTIONS ON APPLIED SUPERCONDUCTIVITY.

[4] Su Sik Bang, Y.-J. S. (2021). Abnormality monitoring for three-phase HTS cable via time-frequency domain reflectometry. IEEE TRANSACTIONS ON APPLIED SUPERCONDUCTIVITY.

[5] Geon Seok Lee, G.-Y. K.-H.-J. (2017). Monitoring electrical and thermal characteristics of HTS cable systems via time-frequency domain reflectometry. IEEE TRANSACTIONS ON APPLIED SUPERCONDUCTIVITY.

[6] Su Sik Bang, G. S.-Y.-J. (2017). Detection of local temperature change on HTS cables via time-frequency domain reflectometry. Journal of Physics: Conference Series, 29th International Symposium on Superconductivity.

[7] Chun-Kwon Lee, G.-Y. K.-J. (2019). Insulation characteristics and fault analysis of HTS cable via stepped frequency waveform reflectometry. IEEE TRANSACTIONS ON APPLIED SUPERCONDUCTIVITY.

**Revendications**

1. Méthode de détection d'une transition fortuite dans une ligne conductrice, comprenant les étapes de :

   - Réaliser (201) au moins une première mesure de réflectométrie de référence sur la ligne conductrice consistant au moins à injecter un signal de test dans la ligne, à mesurer une réflexion du signal de test rétropropagé et en déduire un réflectogramme temporel de référence,
   - Identifier (203) au moins une caractéristique du réflectogramme temporel de référence parmi : la position temporelle d'au moins un pic d'amplitude, un nombre de pics d'amplitude dans le réflectogramme, l'amplitude d'au moins un pic d'amplitude,
   - Réaliser (204) au moins une seconde mesure de réflectométrie sur la ligne conductrice pour obtenir un second réflectogramme temporel,
   - Identifier (205) la même au moins une caractéristique dans le second réflectogramme temporel et,
   - Pour chaque pic d'amplitude identifié, déterminer (206) une différence entre l'au moins une caractéristique mesurée sur le réflectogramme temporel de référence et la même caractéristique mesurée sur le second réflectogramme temporel,

   **caractérisée en ce qu'**elle comprend en outre l'étape suivante :

   - Evaluer (206), sur plusieurs mesures successives si ladite différence augmente en valeur absolue et si c'est le cas, déclencher (207) une alerte correspondant à l'apparition d'une transition fortuite.

2. Méthode de détection d'une transition fortuite selon la revendication 1 dans laquelle l'étape d'évaluer si la différence augmente en valeur absolue consiste à comparer (206) la valeur absolue de la différence à un seuil prédéterminé et à déclencher l'alerte si le seuil est dépassé.

3. Méthode de détection d'une transition fortuite selon l'une quelconque des revendications précédentes dans laquelle l'au moins un pic d'amplitude est le dernier pic d'amplitude du réflectogramme temporel correspondant à une réflexion du signal de test sur l'extrémité de la ligne conductrice.

4. Méthode de détection d'une transition fortuite selon l'une quelconque des revendications précédentes dans laquelle plusieurs mesures de réflectométrie sont réalisées et moyennées (202) respectivement pour déterminer le réflectogramme temporel de référence et le second réflectogramme temporel.

5. Méthode de détection d'une transition fortuite selon l'une quelconque des revendications précédentes dans laquelle la ligne conductrice est une bobine conductrice.

6. Méthode de détection d'une transition fortuite selon la revendication 5 dans laquelle les mesures de réflectométrie sont réalisées en :

- Superposant ladite bobine conductrice à une seconde bobine de référence de longueur inférieure à la longueur de la bobine conductrice, ayant un diamètre de conducteur supérieur au diamètre de conducteur de la bobine conductrice et ayant un diamètre extérieur de la bobine de référence sensiblement identique au diamètre extérieur de la bobine conductrice,
- Connectant un dispositif de réflectométrie apte à réaliser une mesure de réflectométrie au moyen d'un câble coaxial ayant deux conducteurs respectivement reliés à la bobine conductrice et à la seconde bobine de référence.

7. Méthode de détection d'une transition fortuite selon la revendication 6 dans laquelle la seconde bobine de référence est en cuivre.

8. Méthode de détection d'une transition fortuite selon l'une quelconque des revendications 5 à 7 dans laquelle l'au moins une caractéristique d'un réflectogramme temporel correspond à plusieurs pics d'amplitude du réflectogramme temporel et une différence est calculée respectivement entre la position temporelle de chaque pic d'amplitude du réflectogramme temporel de référence et du second réflectogramme.

9. Méthode de détection d'une transition fortuite selon la revendication 8 comprenant une étape de localisation de la transition fortuite sur la ligne conductrice au moyen d'un affichage (707) sur une interface visuelle de l'évolution au cours du temps des différences calculées en fonction de la position temporelle de chaque pic d'amplitude.

10. Méthode de détection d'une transition fortuite selon l'une quelconque des revendications précédentes dans laquelle la ligne conductrice est en matériau supraconducteur et la transition fortuite correspond à une transition d'un état supra à un état résistif.

11. Méthode de détection d'une transition fortuite selon la revendication 10 comprenant en outre une étape de coupure ou diminution du courant (207) dans la ligne conductrice lorsque l'alerte est déclenchée.

12. Système de détection d'une transition fortuite dans une ligne conductrice comprenant un dispositif de réflectométrie apte à réaliser une mesure de réflectométrie dans la ligne conductrice et une unité de traitement configurée pour exécuter les étapes de la méthode de détection d'une transition fortuite selon l'une quelconque des revendications précédentes.

**Patentansprüche**

1. Verfahren zum Erkennen eines zufälligen Übergangs in einer leitfähigen Leitung, umfassend die folgenden Schritte:

   - Durchführen (201) mindestens einer ersten Referenzreflektometriemessung an der leitfähigen Leitung, die mindestens aus dem Einspeisen eines Testsignals in die Leitung, dem Messen einer Reflexion des rückpropagierten Testsignals und dem Ableiten eines zeitlichen Referenzreflektogramms von dieser besteht,
   - Identifizieren (203) mindestens eines Kennzeichens des zeitlichen Referenzreflektogramms aus: der Zeitposition mindestens einer Amplitudenspitze, einer Anzahl von Amplitudenspitzen in dem Reflektogramm, der Amplitude mindestens einer Amplitudenspitze,
   - Durchführen (204) mindestens einer zweiten Reflektometriemessung an der leitfähigen Leitung, um ein zweites zeitliches Reflektogramm zu erhalten,
   - Identifizieren (205) des gleichen mindestens einen Kennzeichens in dem zweiten zeitlichen Reflektogramm, und
   - für jede identifizierte Amplitudenspitze, Bestimmen (206) einer Differenz zwischen dem mindestens einen an dem zeitlichen Referenzreflektogramm gemessenen Kennzeichen und dem gleichen an dem zweiten zeitlichen Reflektogramm gemessenen Kennzeichen,

   **dadurch gekennzeichnet, dass** es ferner den folgenden Schritt umfasst:

   - Bewerten (206), an mehreren aufeinanderfolgenden Messungen, ob der Absolutwert der Differenz ansteigt, und wenn dies der Fall ist, Auslösen (207) einer Warnung entsprechend dem Auftreten eines zufälligen Übergangs.

2. Verfahren zum Erkennen eines zufälligen Übergangs nach Anspruch 1, wobei der Schritt zum Bewerten, ob der Absolutwert der Differenz ansteigt, darin besteht, den Absolutwert der Differenz mit einem vorbestimmten Schwellenwert zu vergleichen (206) und die Warnung auszulösen, wenn der Schwellenwert überschritten wird.

3. Verfahren zum Erkennen eines zufälligen Übergangs nach einem der vorhergehenden Ansprüche, wobei die mindestens eine Amplitudenspitze die letzte Amplitudenspitze des zeitlichen Reflektogramms entsprechend einer Reflexion des Testsignals an dem Ende der leitfähigen Leitung ist.

4. Verfahren zum Erkennen eines zufälligen Übergangs nach einem der vorhergehenden Ansprüche, wobei mehrere Reflektometriemessungen durchgeführt und jeweils gemittelt werden (202), um das zeitliche Referenzreflektogramm und das zweite zeitliche Reflektogramm zu bestimmen.

5. Verfahren zum Erkennen eines zufälligen Übergangs nach einem der vorhergehenden Ansprüche, wobei die leitfähige Leitung eine leitfähige Spule ist.

6. Verfahren zum Erkennen eines zufälligen Übergangs nach Anspruch 5, wobei die Reflektometriemessungen durchgeführt werden durch:

- Überlagern der leitfähigen Spule mit einer zweiten Referenzspule mit geringerer Länge als die Länge der leitfähigen Spule, die einen Leiterdurchmesser größer als der Leiterdurchmesser der leitfähigen Spule aufweist und einen Außendurchmesser der Referenzspule im Wesentlichen identisch zum Außendurchmesser der leitfähigen Spule aufweist,
- Anschließen einer Reflektometrievorrichtung, die in der Lage ist, eine Reflektometriemessung mittels eines Koaxialkabels durchzuführen, das zwei Leiter aufweist, die mit der leitfähigen Spule bzw. der zweiten Referenzspule verbunden sind.

7. Verfahren zum Erkennen eines zufälligen Übergangs nach Anspruch 6, wobei die zweite Referenzspule aus Kupfer besteht.

8. Verfahren zum Erkennen eines zufälligen Übergangs nach einem der Ansprüche 5 bis 7, wobei das mindestens eine Kennzeichen eines zeitlichen Reflektogramms mehreren Amplitudenspitzen des zeitlichen Reflektogramms entspricht und eine Differenz jeweils zwischen der Zeitposition jeder Amplitudenspitze des zeitlichen Referenzreflektogramms und dem zweiten Reflektogramm berechnet wird.

9. Verfahren zum Erkennen eines zufälligen Übergangs nach Anspruch 8, umfassend einen Schritt zum Lokalisieren des zufälligen Übergangs auf der leitfähigen Leitung mittels einer Anzeige (707) auf einer visuellen Schnittstelle der Entwicklung im zeitlichen Verlauf der in Abhängigkeit von der Zeitposition jeder Amplitudenspitze berechneten Differenzen.

10. Verfahren zum Erkennen eines zufälligen Übergangs nach einem der vorhergehenden Ansprüche, wobei die leitfähige Leitung aus einem supraleitenden Material besteht und der zufällige Übergang einem Übergang von einem supraleitenden Zustand zu einem widerstandsfähigen Zustand entspricht.

11. Verfahren zum Erkennen eines zufälligen Übergangs nach Anspruch 10, ferner umfassend einen Schritt zum Unterbrechen oder Verringern des Stroms (207) in der leitfähigen Leitung, wenn die Warnung ausgelöst wird.

12. System zum Erkennen eines zufälligen Übergangs in einer leitfähigen Leitung, umfassend eine Reflektometrievorrichtung, die in der Lage ist, eine Reflektometriemessung in der leitfähigen Leitung durchzuführen, und eine Verarbeitungseinheit, die dafür konfiguriert ist, die Schritte des Verfahrens zum Erkennen eines zufälligen Übergangs nach einem der vorhergehenden Ansprüche auszuführen.

**Claims**

1. A detection method for detecting a random transition in a conducting line, comprising the steps of:

- making (201) at least one first reference reflectometry measurement on the conducting line, consisting in at least injecting a test signal into the line, measuring a reflection of the back-propagated test signal, and deducing therefrom a reference time-domain reflectogram,
- identifying (203) at least one characteristic of the reference time-domain reflectogram from among: the temporal position of at least one amplitude peak, a number of amplitude peaks in the reflectogram, the amplitude of at least one amplitude peak,
- making (204) at least a second reflectometry measurement on the conducting line to obtain a second time-domain reflectogram,
- identifying (205) the same at least one characteristic in the second time-domain reflectogram, and
- for each identified amplitude peak, determining (206) a difference between the at least one characteristic measured on the reference time-domain reflectogram and the same characteristic measured on the second time-domain reflectogram,

**characterised in that** it further comprises the following step of:

- evaluating (206), from several successive measurements, whether said difference increases in absolute value, and, if this is the case, triggering (207) a warning corresponding to the appearance of a random transition.

2. The detection method for detecting a random transition according to claim 1, wherein the step of evaluating whether the difference increases in absolute value consists in comparing (206) the absolute value of the difference with a predetermined threshold and in triggering the warning if the threshold is exceeded.

3. The detection method for detecting a random transition according to any one of the preceding claims, wherein the at least one amplitude peak is the last amplitude peak of the time-domain reflectogram, corresponding to a reflection of the test signal at the end of the conducting line.

4. The detection method for detecting a random transition according to any one of the preceding claims, wherein several reflectometry measurements are made and averaged (202) for determining the reference time-domain reflectogram and the second time-domain reflectogram, respectively.

5. The detection method for detecting a random transition according to any one of the preceding claims, wherein the conducting line is a conducting coil.

6. The detection method for detecting a random transition according to claim 5, wherein the reflectometry measurements are made by:

   - superimposing said conducting coil on a second reference coil whose length is shorter than the length of the conducting coil, having a conductor diameter is greater than the conductor diameter of the conducting coil, and having an outside diameter of the reference coil substantially identical to the outside diameter of the conducting coil,
   - connecting a reflectometry device capable of making a reflectometry measurement by means of a coaxial cable having two conductors linked to the conducting coil and to the second reference coil respectively.

7. The detection method for detecting a random transition according to claim 6, wherein the second reference coil is made of copper.

8. The detection method for detecting a random transition according to any one of claims 5 to 7, wherein the at least one characteristic of a time-domain reflectogram corresponds to several amplitude peaks of the time-domain reflectogram, and a difference is calculated between the temporal position of each amplitude peak of the reference time-domain reflectogram and of the second reflectogram, respectively.

9. The detection method for detecting a random transition according to claim 8, comprising a step of locating the random transition in the conducting line by means of a display (707) on a visual interface of the variation over time of the differences calculated on the basis of the temporal position of each amplitude peak.

10. The detection method for detecting a random transition according to any one of the preceding claims, wherein the conducting line is made of superconducting material, and the random transition corresponds to a transition from a superconducting state to a resistive state.

11. The detection method for detecting a random transition according to claim 10, further comprising a step of cutting or reducing the current (207) in the conducting line when the warning is triggered.

12. A detection system for detecting a random transition in a conducting line, comprising a reflectometry device capable of making a reflectometry measurement in the conducting line and a processing unit configured to execute the steps of the detection method for detecting a random transition according to any one of the preceding claims.

FIG.1a

FIG.1b

Mesures réflectogramme référence — 201

Mesures réflectogramme — 204

Moyenne — 202 — Moyenne

Extraction caractéristique — 203

Extraction caractéristique — 205

Comparaison — 206

Déclenchement alerte — 207

FIG.2

FIG.3

FIG.4

FIG.5

**Nombre de pics par mesure**

601

**Position du pic de fin au cours du temps**

602

**Tension dans la bobine au cours du temps**

603

FIG.6

EP 4 411 395 B1

FIG.7

FIG.8

FIG.9

FIG.10

EP 4 411 395 B1

## RÉFÉRENCES CITÉES DANS LA DESCRIPTION

**Documents brevets cités dans la description**

- US 2021278452 A1

- EP 415709 A

**Littérature non-brevet citée dans la description**

- **GRZEGORZ BEZIUK, A. S.** Locating electrical faults in superconducting accelerator magnets using time domain reflectometry. *IEEE TRANSACTIONS ON APPLIED SUPERCONDUCTIVITY*, 2018
- **IN CHEN, Y. H.** Research on quench detection method using radio frequency wave technology. *IEEE TRANSACTIONS ON APPLIED SUPERCONDUCTIVITY*, 2020
- **GEON SEOK LEE**. Time-frequency-based insulation diagnostic technique oh high-temperature superconducting cable systems. *IEEE TRANSACTIONS ON APPLIED SUPERCONDUCTIVITY*, 2016
- **SU SIK BANG**. Abnormality monitoring for three-phase HTS cable via time-frequency domain reflectometry. *IEEE TRANSACTIONS ON APPLIED SUPERCONDUCTIVITY*, 2021

- **GEON SEOK LEE**. Monitoring electrical and thermal characteristics of HTS cable systems via time-frequency domain reflectometry. *IEEE TRANSACTIONS ON APPLIED SUPERCONDUCTIVITY*, 2017
- **SU SIK BANG**. Detection of local temperature change on HTS cables via time-frequency domain reflectometry. *Journal of Physics: Conference Series, 29th International Symposium on Superconductivity*, 2017
- **CHUN-KWON LEE**. Insulation characteristics and fault analysis of HTS cable via stepped frequency waveform reflectometry. *IEEE TRANSACTIONS ON APPLIED SUPERCONDUCTIVITY*, 2019